# EUROPEAN PATENT SPECIFICATION

(11) **EP 2 983 059 B1**
(45) Date of publication and mention of the grant of the patent: **07.09.2016**
(21) Application number: 14179703.5
(22) Date of filing: 04.08.2014
(51) Int. Cl.: G06F 1/10, G01R 31/3185, G01R 31/317

(54) **Fault protection for clock tree circuitry**
Fehlerschutz für ein Taktverteilungsnetzwerk
Dispositif de protection contre les défaillances pour un circuit d'arborescence d'horloge

(43) Date of publication of application: 10.02.2016
(73) Proprietor: Winbond Electronics Corp., Taichung City 428 (TW)
(72) Inventor: Tasher, Nir, 40600 Tel Mond (IL)
(74) Representative: Fuchs Patentanwälte Partnerschaft mbB

(56) References cited:
- US-A- 4 860 288
- US-A1- 2008 284 483
- US-B1- 7 770 049

## Description

### FIELD OF THE INVENTION

The present invention relates generally to digital electronic circuitry, and particularly to methods and systems for protection from faults in clock tree circuitry.

### BACKGROUND OF THE INVENTION

Various technique are used for accessing, analyzing or extracting information from secure electronic circuitry, such as cryptographic circuitry. Some attacks, referred to as fault injection, typically involve causing a fault in the circuit, e.g., by physically contacting or damaging signal lines, by applying high-power laser or electromagnetic pulses, or by causing glitches on power supply or other external interfaces. The fault is expected to cause the circuit to output sensitive information, or otherwise assist the attacker in penetrating the circuit or the information it stores.

An example for a clock distribution circuit is disclosed in US 2008/284483 A1. The circuit has plural stages of buffers disposed along branch paths for dividing up a clock signal and is configured in a manner that outputs of a plurality of buffers in a final stage and/or a middle stage are short-circuited, includes in relation to at least one buffer of a plurality of buffers in the same stage on a branch path, a selector for receiving an output of an adjacent buffer located upstream in terms of chain-connecting along which the plurality of buffers are connected in testing, and a signal at a branch node corresponding to the at least one buffer by a first input and a second input respectively, selecting one of the first input and the second input based on a select control signal, and supplying the selected input to the one buffer.

### SUMMARY OF THE INVENTION

The present invention is defined by the Integrated Circuit (IC) of claim 1 and the method of claim 6. Additional features are defined in the dependent claims.

An embodiment of the present invention that is described herein provides an Integrated Circuit (IC) including clock-tree circuitry and protection circuitry. The clock-tree circuitry is configured to distribute a clock signal across the IC. The protection circuitry is clocked by multiple instances of the clock signal that are sampled at multiple sampling points in the clock-tree circuitry, and is configured to detect a fault in the clock-tree circuitry in response to an abnormality in one or more of the instances of the clock signal.

In some embodiments, the protection circuitry includes a cascade of logic stages that are clocked by the respective instances of the clock signal, and a detector that is configured to detect the fault by identifying in an output of the cascade a deviation from an expected output. In an embodiment, the logic stages include respective Flip-Flops (FFs). In a disclosed embodiment, the cascade of logic stages is configured to output an alternating pattern of logical values, and the detector is configured to identify the deviation from the alternating pattern.

In an embodiment, the detector is configured to disregard deviations in the output of the cascade that occur within a predefined interval after initialization. In an alternative embodiment, the protection circuitry is configured to initialize the logic stages of the cascade so as to initially produce the expected output. In some embodiments, in response to detecting the fault, the protection circuitry may be configured to issue an alert or act upon the detected fault.

There is additionally provided, in accordance with an embodiment of the present invention, a method including distributing a clock signal across an Integrated Circuit (IC) using clock-tree circuitry. Multiple instances of the clock signal are sampled at multiple respective sampling points in the clock-tree circuitry. Protection circuitry is clocked by the multiple instances of the clock signal. A fault in the clock-tree circuitry is detected, using the protection circuitry, in response to an abnormality in one or more of the instances of the clock signal.

The present invention will be more fully understood from the following detailed description of the embodiments thereof, taken together with the drawings in which:

### BRIEF DESCRIPTION OF THE DRAWINGS

Fig. 1 is a block diagram that schematically illustrates an Integrated Circuit (IC) comprising clock-tree protection circuitry, in accordance with an embodiment of the present invention; and
Fig. 2 is a flow chart that schematically illustrates a method for clock-tree fault protection, in accordance with an embodiment of the present invention.

### DETAILED DESCRIPTION OF EMBODIMENTS

### OVERVIEW

Embodiments that are described herein provide improved methods and systems for detecting faults in Integrated Circuit (IC) clock-tree circuitry. In the disclosed embodiments, an IC comprises clock-tree circuitry (also referred to as "clock tree" for brevity) that distributes a clock signal from a clock source to various hardware units across the IC. The clock-tree circuitry typically comprises circuit traces that span large portions of the IC, as well as active components such as amplifiers, buffers, latches and/or inverters.

In some cases, the clock tree may be subject to fault attacks that attempt to analyze the IC functionality or gain access to information stored in the IC, for example. A fault attack typically applies some constant or temporary abnormality in the clock tree, in an attempt to force the IC into an abnormal state that evades its protection mechanisms. Although the description that follows focuses on fault attacks, the disclosed techniques can also be used for detecting faults that are not caused by attacks.

In some embodiments, the IC comprises protection circuitry that detects, alerts and possibly acts upon fault attacks on the clock tree. The protection circuitry is clocked by multiple instances of the clock signal, which are sampled at multiple sampling points on the clock tree, and identifies a fault in the clock tree by detecting an abnormality in one or more of the clock signal instances.

In an example embodiment, the protection circuitry comprises a cascade of Flip-Flop (FF) stages whose clock inputs are clocked by the respective instances of the clock signal. The first FF stage has its negated output fed-back to its input. Under normal conditions, the output of the cascade is an alternating "1010101010..." pattern. Any deviation from this pattern indicates an abnormality in one or more of the clock inputs of the FF stages, i.e., in one or more of the sampled instances of the clock signal. The processing circuitry comprises a detector, which detects faults in the clock tree by identifying deviations from the expected "101010..." pattern at the cascade output. In alternative embodiments, other suitable patterns (e.g., a pseudo-random yet predictable pattern) can also be used.

The disclosed technique is highly effective and sensitive in detecting various kinds of fault attacks on the clock-tree circuitry. At the same time, the protection circuitry is small and simple to implement.

### SYSTEM DESCRIPTION

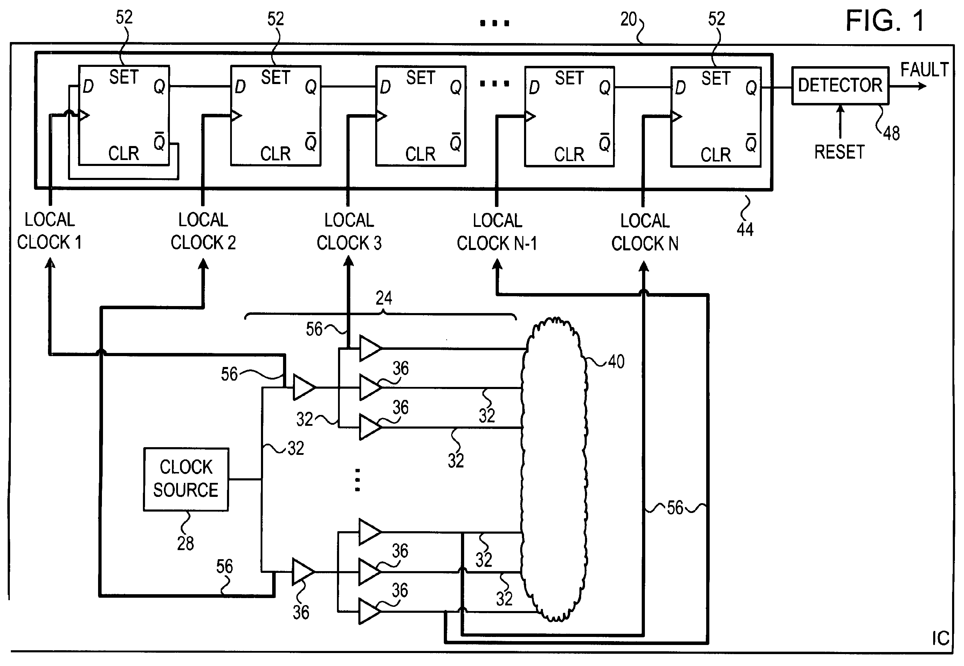

Fig. 1 is a block diagram that schematically illustrates an Integrated Circuit (IC) 20 comprising clock-tree protection circuitry, in accordance with an embodiment of the present invention. IC 20 may comprise, for example, a microprocessor, a memory device, a custom Application-Specific IC (ASIC), a Field-Programmable Gate Array (FPGA) or any other suitable type of IC.

IC 20 comprises a clock tree 24, which distributes a clock signal from a clock source 28 to functional hardware 40 across the IC. Clock tree 24 comprises conductive traces 32, as well as active components 36 such as amplifiers, buffers, latches and/or inverters. Hardware 40 may comprise any suitable number and types of functional units, which are distributed over the area of IC 20 as desired. As such, clock tree 24 may span large portions of the IC area, or even the entire IC.

The beginning of the clock tree, at the clock source, is referred to as a root. From the root toward the functional hardware, the clock-tree circuitry splits into multiple branches. The edges of the branches, which drive the functional hardware, are referred to as leaves.

The example of Fig. 1 refers to a single clock signal and a single clock tree, for the sake of clarity. Real-life ICs often contain multiple clock trees that distribute multiple clock signals. The disclosed techniques are similarly applicable in such ICs, as well.

### CLOCK-TREE FAULT PROTECTION

In some embodiments, IC 20 further comprises protection circuitry for detecting faults in the clock tree, such as faults caused by hostile fault attacks. Such an attack may comprise, for example, cutting the clock tree at one or more points, injecting a voltage glitch at some point or points on the clock tree, forcing a fixed voltage or ground at some point or points on the clock tree, or any other kind of manipulation or abnormality.

In the present example, the protection circuitry of IC 20 comprises a shift register 44, which comprises multiple cascaded Flip-Flop (FF) stages 52, and a detector 48. Multiple sampling lines 56 extract multiple instances of the clock signal from multiple respective sampling points across clock tree 24. The multiple instances of the clock signal are routed to shift register 44 and drive respective clock inputs of FF stages 52. The number of FF stages, and the number of clock-signal instances, is denoted N.

In other words, each FF stage 52 is clocked by a respective instance of the clock signal, which is extracted from a respective sampling point on clock tree 24. Instances of the clock signal may be sampled at the root, at the leaves, or at any intermediate branch of the clock tree. The number and locations of the sampling points may be chosen as desired, for example at random or to protect specific hardware units or functions in the IC.

The first FF stage in the shift register (the leftmost stage in the figure) has its negated (*Q̅*) output fed-back to its input (D). The output (Q) of each FF stage drives the input (D) of the next stage, and the output of the last FF stage serves as output of the cascade.

Under normal steady-state conditions, the signal at the output of the cascade alternates between "1" and "0" at the rate of the clock signal. Steady-state conditions are typically reached N clock cycles after reset or initialization, since the initial states of the FF stages are unpredictable, and N cycles are needed for the alternating "1010101010..." pattern to propagate to the output. In an alternative embodiment, the initial states of FF stages 52 can be set at system initialization to known values that already correspond to the expected pattern. In the present example, even-order FF stages may be reset to logic '0' and odd-order FF stages may be reset to logic '1'.

If a fault occurs at some point or points in the clock tree, e.g., as a result of an attack, one or more of the clock signal instances will exhibit some abnormality. For example, one or more clock signal instances may be shut-off (possibly indicating that the clock tree was cut), one or more clock signal instances may be stuck at some fixed voltage or ground, or a transient glitch may be found on one or more clock signal instances. Alternatively, any other suitable abnormality may show on one or more clock signal instances.

An abnormality in a given instance of the clock signal causes abnormality in clocking the respective FF stage 52 in the protection circuitry. As a result, the output of shift register 44 will deviate from the expected "10101010..." pattern.

In some embodiments, detector 48 monitors the output of shift register 44 and checks for deviations from the expected "10101010..." pattern. The detector is typically also provided with the IC reset signal, in order to disregard the initial interval of N cycles after reset or initialization, during which the shift register output legitimately deviates from the expected pattern.

In response to detecting a deviation from the expected pattern, detector 48 typically triggers a fault alert. The IC protection circuitry may take various actions in response to a fault alert, such as shut down portions of the IC, erase certain data from the IC, issue an external alert, or any other suitable action.

The configurations of IC 20, and in particular the protection circuitry, shown in Fig. 1 are example configurations that are depicted purely for the sake of conceptual clarity. In alternative embodiments, any other suitable IC and/or protection circuitry configuration can be used. For example, the protection circuitry may comprise any other suitable circuit that is clocked by the multiple instances of the clock signal, and whose output is indicative of the presence or absence of faults in the clock tree. Depending on the specific design of the protection circuitry, the expected pattern may have any other suitable format. For example, the pattern may comprise a pseudo-random yet predictable pattern.

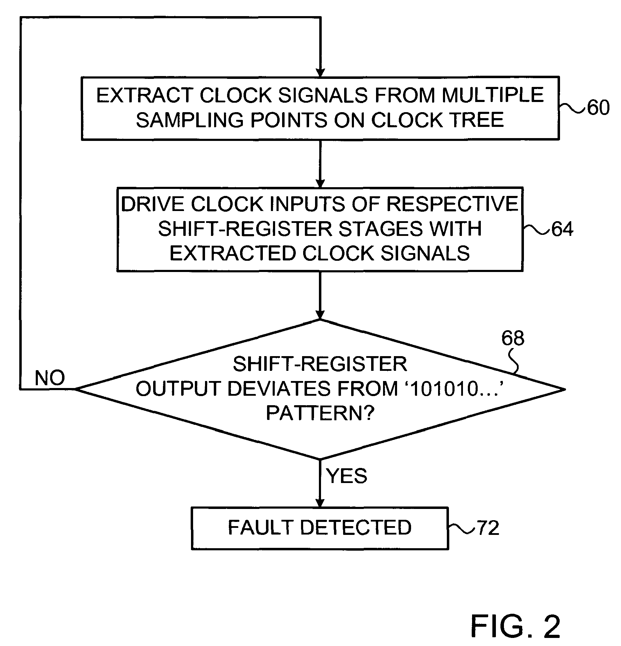

Fig. 2 is a flow chart that schematically illustrates a method for clock-tree fault protection, in accordance with an embodiment of the present invention. The method begins with extracting multiple clock signal instances from multiple sampling points on clock tree 24, at a clock sampling step 60. The extracted clock signal instances drive the clock inputs of respective FF stages 52 of shift register 44, at a clocking step 64.

Detector 48 checks whether the output of shift register 44 deviates from the expected "10101010..." pattern, at a checking step 68. If not, the method loops back to step 60 above. If a deviation is found, detector 48 issues a fault alert, at a fault detection step 72.

It will be appreciated that the embodiments described above are cited by way of example, and that the present invention is not limited to what has been particularly shown and described hereinabove.

## Claims

1. An Integrated Circuit "IC" (20), comprising:
clock-tree (24) circuitry configured to distribute a clock signal across the Integrated Circuit (20); and
a protection circuitry clocked by multiple instances of the clock signal that are sampled at multiple sampling points in the clock-tree (24) circuitry, wherein the Integrated Circuit (20) is **characterized in that**:
the protection circuitry is configured to detect a fault in the clock-tree (24) circuitry in response to an abnormality in one or more of the instances of the clock signal; and
the protection circuitry comprises a cascade of logic stages (52) that are clocked by the respective instances of the clock signal, and a detector (48) that is configured to detect the fault by identifying in an output of the cascade a deviation from an expected output.

2. The IC according to claim 1, wherein the logic stages comprise respective Flip-Flops "FFs".

3. The IC according to claim 1, wherein the cascade of logic stages is configured to output an alternating pattern of logical values, and wherein the detector is configured to identify the deviation from the alternating pattern.

4. The IC according to claim 1, wherein the detector is configured to disregard deviations in the output of the cascade that occur within a predefined interval after initialization.

5. The IC according to claim 1, wherein the protection circuitry is configured to initialize the logic stages of the cascade so as to initially produce the expected output.

6. A method of distributing a clock signal across an Integrated Circuit "IC" (20) using clock-tree (24) circuitry;
sampling multiple instances of the clock signal at multiple respective sampling points in the clock-tree (24) circuitry; and
clocking protection circuitry by the multiple instances of the clock signal; wherein the method is
**characterized in that**:
using the protection circuitry, detecting a fault in the clock-tree (24) circuitry in response to an abnormality in one or more of the instances of the clock signal,
wherein the protection circuitry comprises a cascade of logic stages (52) and a detector (48), wherein clocking the protection circuitry comprises clocking the logic stages using the respective instances of the clock signal, and wherein detecting the fault comprises identifying in an output of the cascade a deviation from an expected output.

7. The method according to claim 6, wherein the logic stages comprise respective Flip-Flops "FFs".

8. The method according to claim 6, wherein clocking the protection circuitry comprises outputting an alternating pattern of logical values, and wherein detecting the fault comprises identifying the deviation from the alternating pattern.

9. The method according to claim 6, wherein identifying the deviation comprises disregarding deviations in the output of the cascade that occur within a predefined interval after initialization.

10. The method according to claim 6, wherein identifying the deviation comprises initializing the logic stages of the cascade so as to initially produce the expected output.

## Patentansprüche

1. Integrierte Schaltung (IC) (20) mit:
einer Taktbaum- (24) Schaltung, die dafür konfiguriert ist, ein Taktsignal über die integrierte Schaltung (20) zu verteilen; und
einer Schutzschaltung, die durch mehrere Instanzen des Taktsignals getaktet wird, die an mehreren Abtastpunkten in der Taktbaum- (24) Schaltung abgetastet werden,
wobei die integrierte Schaltung (20) **dadurch gekennzeichnet ist, dass**
die Schutzschaltung dafür konfiguriert ist, einen Fehler in der Taktbaum- (24) Schaltung in Antwort auf eine Abnormalität in einer oder mehreren der Instanzen des Taktsignalszu erkennen, und
die Schutzschaltung eine Kaskade von Logikstufen (52) aufweist, die durch die jeweiligen Instanzen des Taktsignals getaktet werden, und einen Detektor (48), der dafür konfiguriert ist, den Fehler durch Identifizieren einer Abweichung von einem erwarteten Ausgangssignal in einem Ausgangssignal der Kaskade zu erfassen.

2. Integrierte Schaltung nach Anspruch 1, wobei die Logikstufen jeweils Flip-Flops "FFs" aufweisen.

3. Integrierte Schaltung nach Anspruch 1, wobei die Kaskade von Logikstufen dafür konfiguriert ist, ein alternierendes Muster von Logikwertenauszugeben, und wobei der Detektor dafür konfiguriert ist, die Abweichung vom alternierenden Muster zu identifizieren.

4. Integrierte Schaltung nach Anspruch 1, wobei der Detektor dafür konfiguriert ist, Abweichungen im Ausgangssignal der Kaskade zu ignorieren, die innerhalb eines vorgegebenen Intervalls nach einer Initialisierung auftreten.

5. Integrierte Schaltung nach Anspruch 1, wobei die Schutzschaltung dafür konfiguriert ist, die Logikstufen der Kaskade derart zu initialisieren, dassanfangs das erwartete Ausgangssignal erzeugt wird.

6. Verfahren zum Verteilen eines Taktsignals über eine integrierte Schaltung "IC"(20) unter Verwendung einer Taktbaum- (24) Schaltung, mit den Schritten;
Abtasten mehrerer Instanzen des Taktsignals an mehreren jeweiligen Abtastpunkten in der Taktbaum- (24) Schaltung; und
Takten einer Schutzschaltung durch die mehreren Instanzen des Taktsignals;
wobei das Verfahren **dadurch gekennzeichnet ist, dass**
unter Verwendung der Schutzschaltung ein Fehler in der Taktbaum-(24) Schaltung in Antwort auf eine Abnormalität in einer oder mehreren der Instanzen des Taktsignals erfasst wird,
wobei die Schutzschaltung eine Kaskade von Logikstufen (52) und einen Detektor (48) aufweist, wobei das Takten der Schutzschaltung das Takten der Logikstufen unter Verwendung der jeweiligen Instanzen des Taktsignalsaufweist, und wobei das Erfassen des Fehlers das Identifizieren einer Abweichung von einem erwarteten Ausgangssignal in einem Ausgangssignalder Kaskade aufweist.

7. Verfahren nach Anspruch 6, wobei die Logikstufen jeweils Flip-Flops "FFs" aufweisen.

8. Verfahren nach Anspruch 6, wobei das Takten der Schutzschaltung das Ausgeben eines alternierenden Musters von Logikwerten aufweist, und wobei die Fehlererfassung das Identifizieren der Abweichung vom alternierenden Muster aufweist.

9. Verfahren nach Anspruch 6, wobei das Identifizieren der Abweichung das Ignorieren von Abweichungen im Ausgangssignal der Kaskade aufweist, die innerhalb eines vorgegebenen Intervalls nach einer Initialisierung auftreten.

10. Verfahren nach Anspruch 6, wobei das Identifizieren der Abweichung das Initialisieren der Logikstufen der Kaskade derart aufweist, dassanfangs das erwartete Ausgangssignal erzeugt wird.

## Revendications

1. Circuit intégré "CI" (20) comprenant :
un circuit d'arbre d'horloge (24) configuré pour distribuer un signal d'horloge à travers le circuit intégré (20) ; et
un circuit de protection cadencé par de multiples instances du signal d'horloge qui sont échantillonnées en de multiples points d'échantillonnage dans le circuit d'arbre d'horloge (24),
lequel circuit intégré (20) est **caractérisé en ce que** :
le circuit de protection est configuré pour détecter un défaut dans le circuit d'arbre d'horloge (24) en réponse à une anomalie dans une ou plusieurs des instances du signal d'horloge ; et
le circuit de protection comprend une cascade d'étages logiques (52) qui sont cadencés par les instances respectives du signal d'horloge, et un détecteur (48) qui est configuré pour détecter le défaut en identifiant, dans une sortie de la cascade, un écart par rapport à une sortie prévue.

2. CI selon la revendication 1, dans lequel les étages logiques comprennent des bascules bistables respectives "BB".

3. CI selon la revendication 1, dans lequel la cascade d'étages logiques est configurée pour délivrer en sortie un motif alterné de valeurs logiques, et dans lequel le détecteur est configuré pour identifier l'écart par rapport au motif alterné.

4. CI selon la revendication 1, dans lequel le détecteur est configuré pour ignorer des écarts dans la sortie de la cascade qui se produisent à l'intérieur d'un intervalle prédéfini après l'initialisation.

5. CI selon la revendication 1, dans lequel le circuit de protection est configuré pour initialiser les étages logiques de la cascade de façon à produire initialement la sortie prévue.

6. Procédé de distribution d'un signal d'horloge à travers un circuit intégré "CI" (20) utilisant un circuit d'arbre d'horloge (24) ;
d'échantillonnage d'instances multiples du signal d'horloge en de multiples points d'échantillonnage respectifs dans le circuit d'arbre d'horloge (24) ; et de cadencement du circuit de protection par les instances multiples du signal d'horloge ;
lequel procédé est **caractérisé par** :
la détection, par l'utilisation du circuit de protection, d'undéfaut dans le circuit d'arbre d'horloge (24) en réponse à une anomalie dans une ou plusieurs des instances du signal d'horloge,
dans lequel le circuit de protection comprend une cascade d'étages logiques (52) et un détecteur (48),
dans lequel le cadencement du circuit de protection comprend le cadencement des étages logiques en utilisant les instances respectives du signal d'horloge, et dans lequel la détection du défaut comprend l'identification, dans une sortie de la cascade, d'un écart par rapport à une sortie prévue.

7. Procédé selon la revendication 6, dans lequel les étages logiques comprennent des bascules bistables respectives "BB".

8. Procédé selon la revendication 6, dans lequel le cadencement du circuit de protection comprend la délivrance en sortie d'un motif alterné de valeurs logiques, et dans lequel la détection du défaut comprend l'identification de l'écart par rapport au motif alterné.

9. Procédé selon la revendication 6, dans lequel l'identification de l'écart comprend le fait d'ignorer des écarts dans la sortie de la cascade qui se produisent à l'intérieur d'un intervalle prédéfini après l'initialisation.

10. Procédé selon la revendication 6, dans lequel l'identification de l'écart comprend l'initialisation des étages logiques de la cascade de façon à produire initialement la sortie prévue.
